# EUROPÄISCHE PATENTANMELDUNG

(11) **EP 3 978 647 A1**
(43) Veröffentlichungstag der Anmeldung: **06.04.2022**
(21) Anmeldenummer: 20199291.4
(22) Anmeldetag: 30.09.2020
(51) Int. Cl.: C23C 16/455, C23C 16/458, C30B 25/12, C30B 25/14, H01L 21/687, C23C 16/52, C30B 25/16

(54) **VERFAHREN UND VORRICHTUNG ZUM ABSCHEIDEN EINER EPITAKTISCHEN SCHICHT AUF EINER SUBSTRATSCHEIBE AUS HALBLEITERMATERIAL**

(71) Anmelder: Siltronic AG, 81677 München (DE)
(72) Erfinder: Edmaier, Walter, 84384 Wittibreut (DE); Stettner, Thomas, 83329 Waging am See (DE)
(74) Vertreter: Staudacher, Wolfgang

(57) **Zusammenfassung**

Verfahren und Vorrichtung zum Abscheiden einer epitaktischen Schicht auf einer Substratscheibe aus Halbleitermaterial, die einen keilförmigen Querschnitt mit einem dünneren und einem dickeren Rand aufweist. Das Verfahren umfasst das Anordnen der Substratscheibe und eines Suszeptors in einer Abscheidevorrichtung so, dass die Substratscheibe konzentrisch auf dem Suszeptor aufliegt und der Suszeptor von einer Tragwelle gehalten wird;
das Drehen der Tragwelle mit einer Periodendauer;
das Leiten von Abscheidegas über die Substratscheibe in eine Richtung von einem Gaseinlass zu einem Gasauslass;
das Leiten von Spülgas mit einer Durchflussgeschwindigkeit entlang einer unteren Seite eines Vorheizrings und einer unteren Seite des Suszeptors;
das Verschieben der Tragwelle mit der Periodendauer entlang eines Verschiebewegs in der Richtung ausgehend von einer Anfangsposition, in der der dünnere Rand einen kleinsten Abstand zum Gaseinlass hat, zu einer Endposition, in der der dünnere Rand einen größten Abstand zum Gaseinlass hat, und zurück zur Anfangsposition.

## Beschreibung

Gegenstand der Erfindung ist ein Verfahren zum Abscheiden einer epitaktischen Schicht auf einer Substratscheibe aus Halbleitermaterial, die einen keilförmigen Querschnitt mit einem dünneren und einem dickeren Rand aufweist. Gegenstand der Erfindung ist auch eine Vorrichtung, die zur Durchführung des Verfahrens geeignet ist.

### Stand der Technik / Probleme

Das Abscheiden der epitaktischen Schicht auf einer Substratscheibe aus Halbleitermaterial erfolgt üblicherweise mittels CVD (chemical vapor deposition) in einer Abscheidevorrichtung, die eine Substratscheibe aufnehmen kann. Während des Abscheidens der epitaktischen Schicht liegt die Substratscheibe auf einem Suszeptor, der von einer Tragwelle gehalten und gedreht wird, wobei ein Abscheidegas über eine freie obere Fläche, die Vorderseite der Substratscheibe, geleitet wird. Die Abscheidevorrichtung verfügt üblicherweise auch über einen Vorheizring, der durch einen Spalt getrennt um den Suszeptor herum angeordnet ist. Eine obere und eine untere Kuppel (upper dome, lower dome) definieren einen Reaktionsraum, innerhalb dessen die epitaktische Schicht auf der Substratscheibe abgeschieden wird. Strahlungswärme von Lampenbänken wird durch eine oder beide Kuppeln eingestrahlt, um eine notwendige Abscheidetemperatur bereitzustellen. Eine Abscheidevorrichtung mit diesen Merkmalen ist beispielsweise in US 2016 0 010 239 A1 beschrieben.

Halbleiterscheiben mit einer epitaktischen Schicht (epitaxial wafer) werden für besonders anspruchsvolle Anwendungen in der elektronischen Industrie benötigt. Dementsprechend sind die Anforderungen beispielsweise bezüglich der Gleichmäßigkeit der Dicke einer solchen Halbleiterscheibe besonders herausfordernd.

Ungleichmäßigkeiten der Dicke der Substratscheibe bleiben in der Regel auch nach dem Abscheiden der epitaktischen Schicht erhalten, insbesondere falls die epitaktische Schicht eine einheitliche Dicke hat. Es gibt aber auch Ansätze, die zum Ziel haben, durch das Abscheiden der epitaktischen Schicht die Gleichmäßigkeit der Dicke zu verbessern.

DE 11 2018 001 223 T5 offenbart, dass Spülgas, das entlang einer unteren Seite des Vorheizrings und einer unteren Seite des Suszeptors durch die Abscheidevorrichtung geleitet wird, die Dicke der epitaktischen Schicht beeinflusst, ebenso wie die Breite des Spalts zwischen dem Vorheizring und dem Suszeptor.

In US 2009 0 269 861 A1 wird vorgeschlagen, die Prozessbedingungen während des Abscheidens der epitaktischen Schicht in Abhängigkeit der Ebenheit der Substratscheibe auszuwählen. Ähnliche Vorschläge werden in WO 2018 117 402 A2 und in JP 2002 43 230 A gemacht.

Diesen Vorschlägen ist gemeinsam, dass sie einen Effekt ausnützen, der in Folge des Drehens der Substratscheibe während des Abscheidens der epitaktischen Schicht auftritt: die Änderung von Prozessbedingungen bewirkt eine rotationssymmetrische Änderung der Dickenverteilung der epitaktischen Schicht. Diese Vorschläge eignen sich deshalb nur für Substratscheiben, bei denen die Ungleichmäßigkeit der Dicke rotationssymmetrisch verteilt ist.

Es gibt aber auch Substratscheiben mit einer Dickenverteilung, die nicht rotationssymmetrisch ist. Sie haben einen keilförmigen Querschnitt, wenn die Dicke von einem Bereich des Umfangs bis zum 180° gegenüberliegenden Bereich des Umfangs abnimmt. Der Querschnitt vom dünneren zum dickeren Bereich solcher Substratscheiben hat die Form eines Keils mit einem dünneren Rand und einem dickeren Rand. Das Abscheiden einer epitaktischen Schicht mit rotationssymmetrischer Dickenverteilung kann die keilförmige Struktur nicht beseitigen.

Aufgabe der Erfindung ist es, die Gleichmäßigkeit der Dicke von Halbleiterscheiben mit epitaktischer Schicht zu verbessern, wenn die Substratscheibe einen keilförmigen Querschnitt hat.

Die Aufgabe wird gelöst durch ein Verfahren zum Abscheiden einer epitaktischen Schicht auf einer Substratscheibe aus Halbleitermaterial, die einen keilförmigen Querschnitt mit einem dünneren und einem dickeren Rand aufweist, umfassend das Anordnen der Substratscheibe und eines Suszeptors in einer Abscheidevorrichtung so, dass die Substratscheibe konzentrisch auf dem Suszeptor aufliegt und der Suszeptor von einer Tragwelle gehalten wird;
das Drehen der Tragwelle mit einer Periodendauer;
das Leiten von Abscheidegas über die Substratscheibe in eine Richtung von einem Gaseinlass zu einem Gasauslass;
das Leiten von Spülgas mit einer Durchflussgeschwindigkeit entlang einer unteren Seite eines Vorheizrings und einer unteren Seite des Suszeptors;
das Verschieben der Tragwelle mit der Periodendauer entlang eines Verschiebewegs in der Richtung ausgehend von einer Anfangsposition, in der der dünnere Rand einen kleinsten Abstand zum Gaseinlass hat, zu einer Endposition, in der der dünnere Rand einen größten Abstand zum Gaseinlass hat, und zurück zur Anfangsposition.

Es wird beobachtet, dass Spülgas teilweise durch den Spalt zwischen dem Vorheizring und dem Suszeptor gelangt und das Abscheidegas verdünnt, mit dem Effekt, dass die Rate der Materialabscheidung abnimmt. Der Effekt nimmt mit der Breite des Spalts zu, was erfindungsgemäß ausgenützt wird.

Die Breite des Spalts wird mit dem Abstand des dünneren Rands vom Gaseinlass periodisch vergrößert und die Periodendauer mit der Dauer einer Umdrehung des Suszeptors synchronisiert und zwar so, dass der dünnere Rand der Substratscheibe am Anfang der Periode den kleinsten Abstand zum Gaseinlass hat. Zu diesem Zeitpunkt ist der Verdünnungseffekt am geringsten und die Rate der Materialabscheidung vergleichsweise groß. Eine halbe Umdrehung des Suszeptors später, wenn der dickere Rand den kleinsten Abstand zum Gaseinlass hat, ist der Spalt an dieser Stelle vergleichsweise groß, der Verdünnungseffekt vergleichsweise ausgeprägt und die Materialabscheidung vergleichsweise gering. Die auf der Substratscheibe abgeschiedene epitaktische Schicht hat durch das erfindungsgemäße Vorgehen eine Dickenverteilung, die auch einen keilförmigen Querschnitt hat. Dieser ist jedoch komplementär zu dem des Querschnitts der Substratscheibe, so dass die Keilform der Halbleiterscheibe mit epitaktisch abgeschiedener Schicht zumindest geringer ausgeprägt ist, als diejenige der Substratscheibe. Das erfindungsgemäße Verfahren ist auch geeignet, um eine Substratscheibe mit keilförmiger Form in eine Halbleiterscheibe mit epitaktischer Schicht und einer Form zu transformieren, die der einer Scheibe mit nahezu planparallelen Vorderseite und Rückseite entspricht.

Die Substratscheibe hat einen keilförmigen Querschnitt im Sinne der vorliegenden Erfindung, wenn die Ränder des Querschnitts unterschiedlich dick sind. Ein stetiger Anstieg der Dicke vom dünneren Rand bis zum dickeren Rand ist bevorzugt, aber nicht unbedingt notwendig.

Die Substratscheibe wird auf einem Suszeptor abgelegt. Der Suszeptor hat in der Draufsicht einen kreisförmigen Außenumfang und weist vorzugsweise eine Vertiefung (pocket) und eine Ablagefläche auf, auf der die Substratscheibe im Randbereich von deren Rückseite aufliegt. Die Substratscheibe liegt konzentrisch zum Außenumfang des Suszeptors und vorzugsweise derart auf dessen Ablagefläche, dass zwischen der Rückseite der Substratscheibe und einem die Vertiefung begrenzenden Boden ein Abstand vorhanden ist. Im Boden der Vertiefung können Löcher eingearbeitet sein, um den Transport von Dotierstoffen von der Rückseite der Substratscheibe in den Reaktionsraum unter dem Suszeptor zu erleichtern. Anstelle der Löcher kann der Boden aus faserhaltigem Material bestehen und wegen der Porosität des Materials den Transport von Dotierstoffen gewährleisten.

Um zu erreichen, dass die Breite des Spalts zwischen dem Vorheizring und dem Suszeptor in der vorgesehenen Weise während des Abscheidens der epitaktischen Schicht variiert, wird die Tragwelle, mittels derer der Suszeptor gehalten wird, periodisch von einer Angangsposition in eine Endposition und zurück in die Anfangsposition verschoben. Das Verschieben der Tragwelle erfolgt mittels mindestens eines Aktuators, beispielsweise über ein oder mehrere piezoelektrische Stellelemente. Der Verschiebeweg zwischen der Anfangsposition und der Endposition führt entlang einer Richtung zwischen dem Gaseinlass und dem Gasauslass. Über die Dauer von einer Umdrehung des Suszeptors betrachtet, hat der dünnere Rand des Querschnitts des Substrats in der Anfangsposition den kleinsten Abstand zum Gaseinlass und in der Endposition den größten Abstand zum Gaseinlass.

Die Länge des Verschiebewegs von der Anfangsposition bis zur Endposition beträgt vorzugsweise nicht weniger als 30 % und nicht mehr als 130 % der Breite des Spalts, die vorliegt, wenn der Außenumfang des Suszeptors und der Innenumfang des Vorheizrings konzentrisch angeordnet sind. Die Länge des Verschiebewegs ist vorzugsweise proportional zur Differenz der Dicken am dickeren Rand und am dünneren Rand des Querschnitts.

Der Suszeptor wird mit einer Drehgeschwindigkeit von vorzugsweise 30 Umin⁻¹ bis 60 Umin⁻¹ gedreht. Bei einer solchen Drehgeschwindigkeit beträgt die Periodendauer der Verschiebebewegung des Suszeptors 1 s bis 2 s.

Vorzugsweise wird die Form der Substratscheibe vor dem Abscheiden der epitaktischen Schicht gemessen und Prozessparameter der Abscheidung wie die Geschwindigkeit der Verschiebebewegung und die Durchflussgeschwindigkeit des Spülgases der Form angepasst.

Die Geschwindigkeit der Verschiebebewegung kann im Wesentlichen konstant sein oder an den Verlauf der Dickenänderung entlang des Umfangs der Substratscheibe angepasst geändert werden.

Die Durchflussgeschwindigkeit des Spülgases, die die radiale Reichweite des Effekts mitbestimmt, der mit der Verdünnung des Abscheidegases einhergeht, beträgt vorzugsweise nicht weniger als 5 slm und nicht mehr als 30 slm. Sie kann konstant sein oder an den Verlauf der Dickenänderung entlang des Umfangs der Substratscheibe angepasst geändert werden.

Die Substratscheibe besteht aus Halbleitermaterial, vorzugsweise aus einkristallinem Silizium, ebenso wie die epitaktische Schicht, die auf der Vorderseite der Substratscheibe abgeschieden wird. Der Durchmesser der Substratscheibe beträgt vorzugsweise mindestens 200 mm, besonders bevorzugt mindestens 300 mm.

Das Abscheidegas enthält eine das Halbleitermaterial enthaltende Verbindung, beispielsweise Silan oder ein Chlorsilan, beispielsweise Trichlorsilan, das Spülgas vorzugsweise Wasserstoff.

Das erfindungsgemäße periodische Verschieben der Tragwelle muss während des Abscheidens der epitaktischen Schicht nicht durchgängig erfolgen. Es kann auch nur zeitweise erfolgen. So sieht eine weitere Ausführungsform der Erfindung vor, die epitaktische Schicht bis zu einer bestimmten Schichtdicke abzuscheiden, ohne dass die Tragwelle periodisch verschoben wird, und danach mit dem Abscheiden der epitaktischen Schicht fortzufahren, während die Tragwelle erfindungsgemäß verschoben wird. Dieses Vorgehen kann auch so abgewandelt werden, dass zunächst die epitaktische Schicht abgeschieden wird, während die Tragwelle periodisch verschoben wird, und das Abscheiden der epitaktischen Schicht danach fortgesetzt wird, ohne dass die Tragwelle verschoben wird. Gemäß einer dieser Ausführungsformen vorzugehen, ist besonders zweckmäßig, wenn die Keilform der Substratscheibe vergleichsweise schwach ausgeprägt ist.

Des Weiteren wird die Aufgabe gelöst durch eine Vorrichtung zum Abscheiden einer epitaktischen Schicht auf einer Substratscheibe aus Halbleitermaterial, umfassend einen Suszeptor,
einen Vorheizring,
eine Tragwelle,
mindestens einen Aktuator zum Verschieben der Tragwelle, und
eine Steuerungseinrichtung konfiguriert zum periodischen Verschieben der Tragwelle mittels des Aktuators entlang einer Richtung von einem Gaseinlass zu einem Gasauslass.

Gemäß einer bevorzugten Ausführungsform umfasst die Vorrichtung auch mindestens einen Aktuator zum Kippen der Tragwelle. Nach dem Kippen der Tragwelle steht die Drehachse der Tragwelle nicht mehr senkrecht, sondern ist zum Vorheizring hin gekippt.

Die Erfindung wird nachfolgend unter Bezugnahme auf Zeichnungen weiter vorgestellt.

### Kurzbeschreibung der Figuren

**Fig. 1** zeigt eine Vorrichtung in Schnittdarstellung, die zur Durchführung des erfindungsgemäßen Verfahrens geeignet ist.
**Fig. 2** zeigt weitere Einzelheiten der Vorrichtung.
**Fig. 3** zeigen den Anfang und das Ende des Verschiebens der Tragwelle im Verlauf einer 180°-Drehung des Suszeptors.
**Fig. 4** zeigt zum Vergleich den Querschnitt einer keilförmigen Substratscheibe und den einer erfindungsgemäß beschichteten Substratscheibe.

### Liste der verwendeten Bezugszeichen

- **1**: Substratscheibe
- **2**: Suszeptor
- **3**: Vorheizring
- **4**: Ablagefläche
- **5**: Spalt
- **6**: Bildausschnitt
- **7**: Kamerasystem
- **8**: Bildverarbeitung
- **9**: Tragwelle
- **10**: Tragarm
- **11**: Hebewelle
- **12**: Basis
- **13**: Aktuator
- **14**: Aktuator
- **15a,b**: Gaseinlass
- **16a,b**: Gasauslass
- **17**: obere Kuppel
- **18**: untere Kuppel
- **19**: Lampenbank
- **20**: Abscheidevorrichtung
- **21**: Steuerungseinrichtung
- **22**: Drehachse
- **23**: Rückseite
- **24**: Boden
- **25**: Faltenbalg
- **26**: dünnerer Rand
- **27**: dickerer Rand
- **28**: epitaktische Schicht

### Detaillierte Beschreibung eines erfindungsgemäßen Ausführungsbeispiels

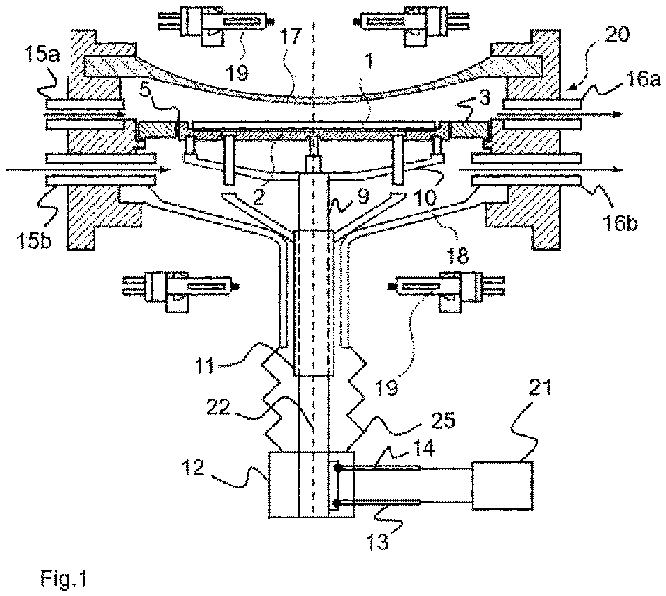

Fig.1 zeigt in Schnittdarstellung eine Vorrichtung zum Abscheiden einer epitaktischen Schicht auf einer Substratscheibe aus Halbleitermaterial, die zur Durchführung des erfindungsgemäßen Verfahrens geeignet ist. Der Reaktionsraum dieser Abscheidevorrichtung 20 ist nach oben durch eine obere Kuppel 17 und nach unten durch eine untere Kuppel 18 begrenzt. In die Mitte des Reaktionsraums ragt eine Tragwelle 9, von der an einem oberen Ende Tragarme 10 abzweigen. Die Tragarme 10 stützen einen Suszeptor 2, auf dem während des Abscheidens einer epitaktischen Schicht eine Substratscheibe 1 liegt. Bei der gezeigten Ausführungsform ist vorgesehen, die Substratscheibe 1 im Zuge des Beladens der Abscheidevorrichtung 20 auf einer Hebewelle 11 abzulegen und durch Absenken der Hebewelle 11 auf dem Suszeptor 2 abzulegen. Zwischen der Seitenwand der Abscheidevorrichtung und dem Suszeptor 2 ist ein Vorheizring 3 angeordnet. Das Abscheidegas wird über eine zur oberen Kuppel 17 zeigende Vorderseite der Substratscheibe von einem Gaseinlass 15a zu einem Gasauslass 16a geleitet, die an einer Seitenwand der Abscheidevorrichtung angeordnet sind. Des Weiteren ist auch ein entsprechender Gaseinlass 15b und Gasauslass 16b für Spülgas vorgesehen, das unter dem Vorheizring 3 und dem Suszeptor 2 durch den Reaktionsraum geleitet wird. Pfeile deuten die Fließrichtung der Gasflüsse an. Abhängig von der Breite eines Spalts 5 zwischen dem Vorheizring und dem Suszeptor gelangt ein Teil des Spülgases in den Strom des Abscheidegases und verdünnt das Abscheidegas. Von außen wird der Reaktionsraum durch Lampenbänke 19 beheizt, die Strahlungsenergie durch die obere und untere Kuppel 17 und 18 einstahlen. Die untere Kuppel 18 der Abscheidevorrichtung 20 ist mit der Basis 12 durch einen Faltenbalg 25 verbunden, um das Bewegen der Tragwelle 9 zu ermöglichen und um den durch ihn geschaffenen Innenraum gegen einströmende Umgebungsatmosphäre abzudichten.

Besonderes Merkmal der Vorrichtung ist eine Steuerungseinrichtung 21, die konfiguriert ist, die Tragwelle 9 mittels mindestens eines Aktuators 13 entlang einer Richtung vom Gaseinlass 15a, 15b zum Gasauslass 16a, 16b periodisch zu verschieben. Die gezeigte Ausführungsform verfügt über zwei Aktuatoren 13 und 14, die bei gleichartiger Aktivierung die Tragwelle 9 verschieben. Darüber hinaus ist auch das Kippen der Tragwelle 9 möglich, wenn die Aktivierung unterschiedlich ist. Beim Kippen neigt sich die Drehachse 22 der Tragwelle 9 aus der Vertikalen zum Vorheizring 3. Das zusätzliche Kippen der Tragwelle 9 kann beispielsweise nützlich sein, um die Substratscheibe 1 in eine horizontale Lage zu bringen, falls sie nicht wie vorgesehen horizontal auf dem Suszeptor 2 aufliegt.

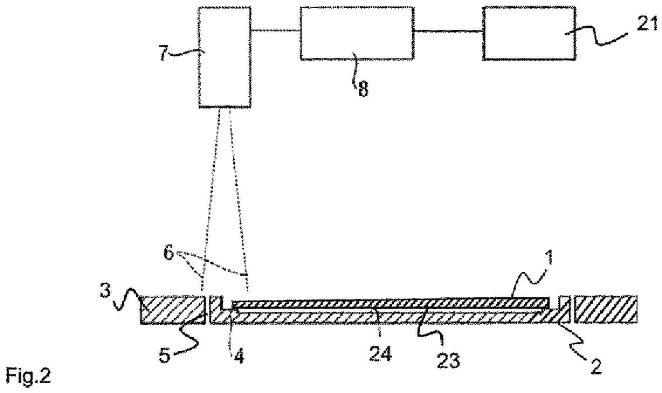

Es ist daher von Vorteil, auch ein Kamerasystem 7 mit Bildverarbeitung 8 vorzusehen, um die Lage der Substratscheibe 1 zu überprüfen. Das in Fig.2 gezeigte Kamerasystem 7 umfasst eine Kamera zum Beobachten eines Bildausschnitts 6 während des Drehens des Suszeptors 2 mittels der Tragwelle 9. Der Bildausschnitt 6 erfasst einen sich radial erstreckenden Bereich, der vorzugsweise einen Abschnitt des äußeren Umfangs der Substratscheibe 1, einen Abschnitt des äußeren Umfangs des Suszeptors 2, und einen Abschnitt des inneren Umfangs des Vorheizrings 3 einschließt und damit auch einen Abschnitt des Spalts 5 zwischen dem Suszeptor 2 und dem Vorheizring 3. Die Substratscheibe 1 liegt in einer Vertiefung (pocket) des Suszeptors 2 auf einer Ablagefläche 4, so dass die Rückseite 23 der Substratscheibe 1 Abstand zum Boden 24 des Suszeptors 2 hat. Die im Bildausschnitt 6 enthaltenen Informationen werden mittels der Bildverarbeitung 8 insbesondere bezüglich der Breite des Spalts 5 und des Abstands des Kamerasystems 7 zum Suszeptor 2 ausgewertet. Mittels der Steuerungseinrichtung 21 wird geprüft, ob eine Fehlanordnung des Suszeptors 2 vorliegt und gegebenenfalls ein Signal erzeugt, welches die Tragwelle 9 soweit kippt, dass die Substratscheibe von der Fehlanordnung in die vorgesehene horizontale Lage gelangt.

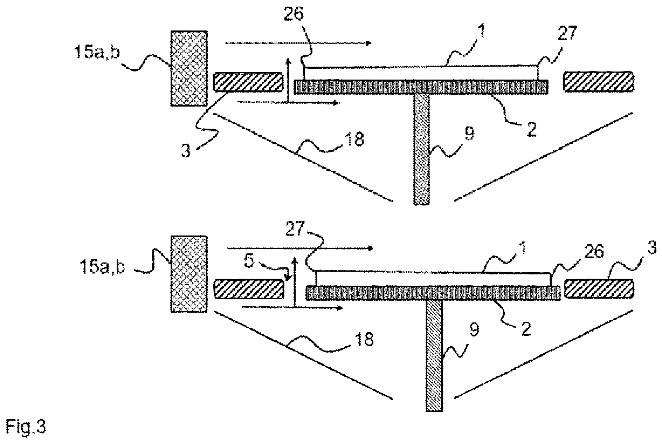

Erfindungsgemäß wird die Tragwelle periodisch entlang eines Verschiebewegs von einer Anfangsposition zu einer Endposition und zurück zur Anfangsposition verschoben. Der Anfang (oben) und das Ende (unten) einer solchen Bewegung bis zur Endposition der Tragwelle 9 sind in Fig.3 skizziert. Die Substratschiebe 1 liegt zentrisch auf der Ablagefläche des Suszeptors 2. Sie hat einen keilförmigen Querschnitt mit einem dünneren Rand 26 und einem dickeren Rand 27. Im Verlauf einer Umdrehung des Suszeptors 1 hat der dünnere Rand in der Anfangsposition der Tragwelle 9 den kleinsten Abstand zum Gaseinlass 15 a,b und in der Endposition der Tragwelle 9 den größten Abstand zum Gaseinlass 15 a,b. Wegen des Verschiebens der Tragwelle 9 ist der Spalt 5 zwischen dem Vorheizring 3 und dem Suszeptor 2 in der Anfangsposition der Tragwelle 9 auf der Seite des Gaseinlasses 15 a,b kleiner, und der Verdünnungseffekt durch Spülgas, das entlang des geteilt gezeichneten Pfeils in den Raum über dem Suszeptor gelangt, kleiner. Gelangt der dickere Rand der Substratscheibe beim Drehen des Suszeptors 2 in die Nähe des Gaseinlasses 15 a,b ist der Spalt 5 größer, und ebenso der Verdünnungseffekt. Das hat die Wirkung, dass insgesamt mehr Material im Bereich des dünneren Rands 26 abgeschieden wird, als im Bereich des dickeren Rands 27 der Substratscheibe 1.

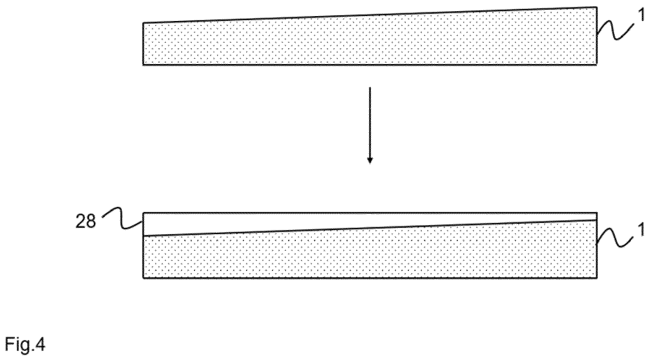

In Fig.4 ist dargestellt, wie sich der Querschnitt der Substratscheibe mit abgeschiedener epitaktischer Schicht (unten) im Vergleich zum Querschnitt der Substratscheibe (oben) ändert. Die epitaktische Schicht 28 hat ebenfalls einen keilförmigen Querschnitt, der jedoch komplementär zu demjenigen der Substratscheibe 1 ist, so dass die beschichtete Substratscheibe im Idealfall planparallele Seitenflächen aufweist.

## Patentansprüche

1. Verfahren zum Abscheiden einer epitaktischen Schicht auf einer Substratscheibe aus Halbleitermaterial, die einen keilförmigen Querschnitt mit einem dünneren und einem dickeren Rand aufweist, umfassend
das Anordnen der Substratscheibe und eines Suszeptors in einer Abscheidevorrichtung so, dass die Substratscheibe konzentrisch auf dem Suszeptor aufliegt und der Suszeptor von einer Tragwelle gehalten wird;
das Drehen der Tragwelle mit einer Periodendauer;
das Leiten von Abscheidegas über die Substratscheibe in eine Richtung von einem Gaseinlass zu einem Gasauslass;
das Leiten von Spülgas mit einer Durchflussgeschwindigkeit entlang einer unteren Seite eines Vorheizrings und einer unteren Seite des Suszeptors;
das Verschieben der Tragwelle mit der Periodendauer entlang eines Verschiebewegs in der Richtung ausgehend von einer Anfangsposition, in der der dünnere Rand einen kleinsten Abstand zum Gaseinlass hat, zu einer Endposition, in der der dünnere Rand einen größten Abstand zum Gaseinlass hat, und zurück zur Anfangsposition.

2. Verfahren nach Anspruch 1, **dadurch gekennzeichnet, dass** die Länge des Verschiebewegs von der Anfangsposition bis zur Endposition proportional zur Differenz der Dicken am dickeren Rand und am dünneren Rand des Querschnitts ist.

3. Verfahren nach Anspruch 1 oder Anspruch 2, **dadurch gekennzeichnet, dass** die Form der Substratscheibe vor dem Abscheiden der epitaktischen Schicht gemessen und die Geschwindigkeit des Verschiebens der Tragwelle in Abhängigkeit der Form geändert wird.

4. Verfahren nach einem der Ansprüche 1 bis 3, **dadurch gekennzeichnet, dass** die Form der Substratscheibe vor dem Abscheiden der epitaktischen Schicht gemessen und die Durchflussgeschwindigkeit des Spülgases in Abhängigkeit der Form geändert wird.

5. Verfahren nach einem der Ansprüche 1 bis 4, **dadurch gekennzeichnet, dass** die Tragwelle zum Vorheizring hin gekippt wird.

6. Vorrichtung zum Abscheiden einer epitaktischen Schicht auf einer Substratscheibe aus Halbleitermaterial, umfassend
einen Suszeptor,
einen Vorheizring,
eine Tragwelle,
mindestens einen Aktuator zum Verschieben der Tragwelle, und
eine Steuerungseinrichtung konfiguriert zum periodischen Verschieben der Tragwelle mittels des Aktuators entlang einer Richtung von einem Gaseinlass zu einem Gasauslass.

7. Vorrichtung nach Anspruch 6, **gekennzeichnet durch** mindestens einen weiteren Aktuator zum Kippen der Tragwelle hin zum Vorheizring.

8. Vorrichtung nach Anspruch 6 oder Anspruch 7, **gekennzeichnet durch** ein Kamerasystem zum Beobachten eines äußeren Rands der Substratscheibe und eines Spalts zwischen dem Suszeptor und dem Vorheizring.
